# EUROPÄISCHE PATENTSCHRIFT

(11) **EP 0 369 053 B1**
(45) Veröffentlichungstag und Bekanntmachung des Hinweises auf die Patenterteilung: **02.03.1994**
(21) Anmeldenummer: 88119094.6
(22) Anmeldetag: 17.11.1988
(51) Int. Cl.: H01L 21/00, H01L 21/76

(54) **Verfahren zur Herstellung von Masken mit Strukturen im Submikrometerbereich**
Method of manufacturing masks with structures in the submicrometer region
Procédé pour fabriquer des masques comportant des structures dans la région submicrométrique

(43) Veröffentlichungstag der Anmeldung: 23.05.1990
(73) Patentinhaber: International Business Machines Corporation, Armonk, N.Y. 10504 (US)
(72) Erfinder: Koblinger, Otto, Dr., D-7015 Korntal-Münchingen 2 (DE); Meissner, Klaus, Dipl.-Phys., D-7403 Ammerbuch-Altingen (DE); Mühl, Reinhold, D-7031 Gärtringen (DE); Trumpp, Hans-Joachim, Dr. Dipl.-Phys., D-7024 Bernhausen (DE); Zapka, Werner, Dr. Dipl.-Phys., D-7031 Gärtringen-Rohrau (DE)
(74) Vertreter: Schäfer, Wolfgang, Dipl.-Ing.

(56) Entgegenhaltungen:
- EP-A- 0 010 624
- EP-A- 0 111 086
- EP-A- 0 223 032
- EP-A- 0 280 587
- US-A- 4 331 708
- US-A- 4 354 896
- US-A- 4 648 937

## Beschreibung

Die Erfindung betrifft ein Verfahren zur Herstellung von Masken mit Strukturen im Submikrometerbereich.

Im Zuge der Miniaturisierung von Komponenten in integrierten Schaltkreisen müssen in Zukunft Strukturen mit Abmessungen, die weit unter 1 µm liegen, hergestellt werden können. Die in den Verfahren zur Herstellung solcher Submikrometerstrukturen bisher verwendeten Masken wurden mittels direkt schreibender Elektronenstrahl- oder Ionenstrahllithographie hergestellt. Mit diesen Verfahren konnten Lithographiemasken mit einem Maskenfeld von beispielsweise 5 x 5 mm (Größe eines Chipfeldes) und minimalen Linienbreiten von etwa 0.5 µm hergestellt werden.

Da in Zukunft wesentlich größere Chipfelder mit noch feineren Strukturen hergestellt werden sollen, müssen auch die hierfür benötigten größeren Masken mit der entsprechenden Genauigkeit hergestellt werden können. Bei direkt schreibenden Elektronenstrahl-Belichtungssystemen ist die beschreibbare Feldgröße aber durch Feldinhomogenitäten und durch die gewünschten feineren Linienbreiten (bei konstanter Anzahl der Adreßpunkte wird bei Übergang zu kleineren Linienbreiten der Abstand der Adreßpunkte und damit das beschreibbare Feld kleiner) begrenzt. Deshalb können größere Felder nur hergestellt werden, indem man mehrere kleinere Felder nacheinander beschreibt und diese zu einem größeren Feld zusammensetzt. Die einzelnen Felder müssen dabei möglichst genau aneinander anschließen, damit die Positionierfehler, die bei diesem Anschließen der Felder auftreten, etwa 1/3 der minimalen Linienbreite nicht überschreiten. Insgesamt wird bei der Herstellung von Masken für zukünftige hochintegrierte Schaltkreise die Anzahl der Positionierfehler wegen der feineren Strukturen, bzw. des dadurch bedingten kleineren beschreibbaren Feldes und wegen des gewünschten größeren Maskenfeldes, bzw. der dadurch bedingten größeren Zahl von Nahtstellen pro Maskenfeld (Chipfeld) zunehmen, so daß die Herstellung von 1:1 Masken für die zukünftige Lithographie fraglich wird.

Aufgabe der Erfindung ist ein Verfahren zur Herstellung von Masken anzugeben, bei dem die feinsten zu schreibenden Linienbreiten mittels der sog. Seitenwandtechnologie als Lochmuster in der Maske realisiert werden und weitere, beliebige Linienstrukturen in der Maske in einem photolithographischen Prozeß mittels eines direkt schreibenden Elektronenstrahl- oder Ionenstrahlschreibers oder auch durch optische Belichtung hergestellt werden.

Die Aufgabe der Erfindung wird gelöst durch ein Verfahren gemäß Patentanspruch 1.

Mit dem erfindungsgemäßen Verfahren können in einem ersten Abschnitt mittels der Seitenwandtechnologie und damit mittels optischer Lithographie Muster von Linien mit einer minimalen Linienbreite von etwa 0.1 µm zuverlässig hergestellt werden. Im gleichen Verfahrensabschnitt werden in der Maske Registriermarken hergestellt, mit deren Hilfe eine weitere Belichtung auf die Maske mit höchst genauer Überlagerung vorgenommen werden kann. In einem zweiten Abschnitt können dann in der Maske, beispielsweise mittels Elektronenstrahllithographie, beliebig geformte Linienstrukturen mit Linienbreiten größer als etwa 0.5 µm hergestellt werden.

In dem Verfahren gemäß der Erfindung werden Strukturen aus Polymermaterial mit vertikalen Seitenwänden auf einer Oxidschicht hergestellt, die sich auf einem Siliciumsubstrat befindet, in dem die gewünschte Maske realisiert werden soll. Die Seitenwände dienen zur Ausbildung von Seitenwandstrukturen aus Siliciumnitrid oder Oxid mit Abmessungen im Submikrometerbereich. In einem hochpräzisen Umkopierprozess wird die ursprüngliche Dimension der Seitenwände in die Oxidschicht auf dem Substrat übertragen. Die resultierende strukturierte Oxidschicht dient als Maske zum Ätzen von Gräben in das Substrat. Anschließend werden in einem zweiten Lithographieverfahren die hinsichtlich ihrer Abmessungen weniger kritischen Strukturen in der Maske hergestellt.

Die Erfindung wird im folgenden unter Zuhilfenahme der Zeichnungen näher erläutert.

Es zeigen:
- Fig. 1A:: eine Maske, die aus mehreren Feldern zusammengesetzt ist;
- Fign. 1 B, C:: Druckmuster von Linien unterschiedlicher Linienbreite und die korrespondierenden Resistmuster;
- Fign. 2 bis 7:: den Ablauf des 1. Abschnitts des Verfahrens gemäß der Erfindung zur Herstellung der feinsten Linienbreiten;
- Fig. 8:: eine Siliciumdioxidmaske mit Öffnungen unterschiedlichen Durchmessers und in das Siliciumsubstrat geätzten Gräben;
- SEMs 1 bis 5:: Sekundärelektronenmikroskop- oder Rasterelektronenmikroskopaufnahmen, welche den Fign. 4 bis 8 entsprechen;
- Fig. 9:: eine fertige Maske nach dem ersten und zweiten Abschnitt des Verfahrens gemäß der Erfindung.

Verfahren zur Herstellung von Strukturen mit Abmessungen im Submikrometerbereich unter Verwendung von Strukturen aus Polymermaterial mit vertikalen Seitenwänden sind in der Europäischen Patentschrift 0 111 086 (EPA 83109945.2) beschrieben. Dort ist auch eine Anwendung dieses Verfahrens zur Herstellung einer tiefen dielektrischen Isolation von Submikrometerbreite in einem Siliciumkörper beschrieben. Zur Herstellung einer Maske nach dem Verfahren gemäß der Erfindung wird zwar von der Seitenwandtechnologie der zuvor genannten Europäischen Patentschrift Gebrauch gemacht, der Umkopierprozeß der Seitenwandstrukturen in die Oxidschicht auf dem Substrat ist aber ein anderer als der dort beschriebene.

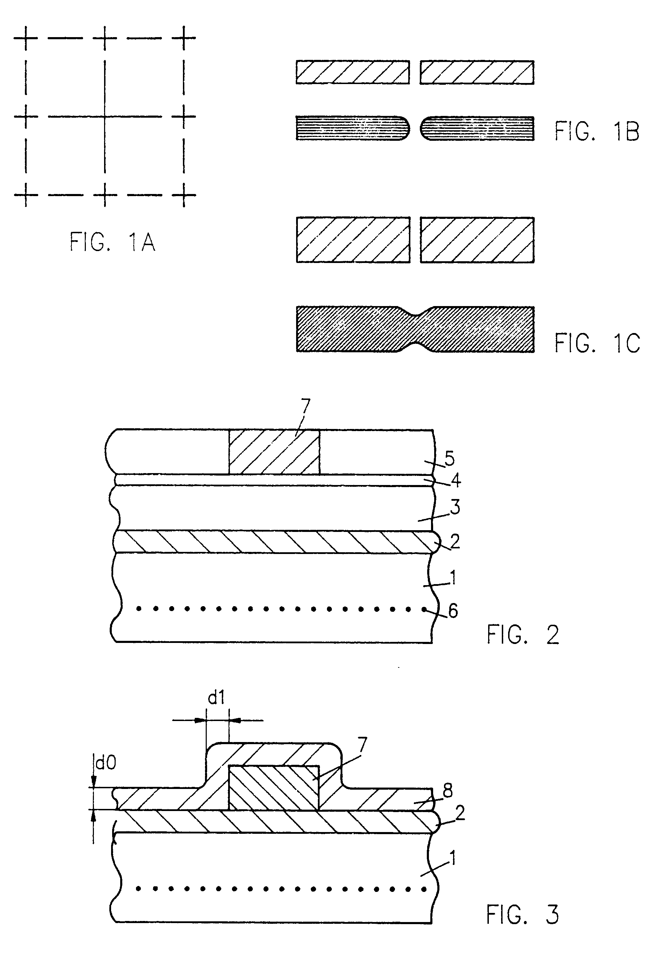

Fig. 1A zeigt eine Maske, deren Maskenfeld aus vier kleineren Feldern zusammengesetzt ist. Überlagerungsfehler, die beim Zusammensetzen des Maskenfeldes aus einzelnen Feldern auftreten können, wirken sich bei den empfindlichen feinsten Linien von etwa 0.25 µm Breite besonders nachteilig aus. In der Praxis können solche Fehler beim Zusammensetzen einzelner kleinerer Felder zu einem größeren Chipfeld auftreten, was zu Unterbrechungen z. B. der sehr feinen Wort-Bit-Linien führt, die rasterartig auf dem Chip angeordnet sind. Im vorliegenden Fall ist in Fig. 1 B (oben) das Druckmuster für eine feine Linie gegeben. Bei einer Unterbrechung dieses Musters, beispielsweise durch Überlagerungsfehler, ist das resultierende Resistmuster Fig. 1 B (unten) ebenfalls unterbrochen. Bei gröberen Linien wirkt sich eine Unterbrechung des Druckmusters Fig. 1 C (oben) nur dahingehend aus, daß das resultierende Resistmuster in diesem Bereich eine Einschnürung erfährt, Fig. 1 C (unten). Wenn im letzteren Fall die Linienbreite um etwa 1/3 reduziert ist, ist die Struktur noch brauchbar. Die Ursache für die Linienunterbrechung beim Zusammensetzen feiner Linien ist das geringe Ausmaß der Doppelbelichtung zwischen beiden Linien. Bei breiteren Linien ist der Grad der Doppelbelichtung zwischen den beiden Linien wesentlich höher, so daß in der Regel auch die nicht direkt bestrahlten Bereiche zwischen denselben "geöffnet" werden, was zu einer Einschnürung, nicht aber zu einer Öffnung führt. Mit dem Verfahren gemäß der Erfindung können gerade die gegenüber Überlagerungsfehlern besonders empfindlichen feinen Linien mittels großflächiger optischer Lithographie hergestellt werden, wodurch die in Fig. 1 B gezeigten Fehler vermieden werden können.

Nachfolgend wird anhand der Fign. 2 bis 9 (SEMs 1 bis 5) die Herstellung einer Maske im Detail beschrieben. Gemäß Fig. 2 wird auf ein Siliciumhalbleitersubstrat (1) eine Schicht (2) aus dielektrischem Material nach üblichen Verfahren aufgetragen. Die Schicht (2) kann beispielsweise aus Siliciumdioxid bestehen. Sie kann aber auch aus einer Doppelschicht oder aus einer Folge von Schichten bestehen.

In dem Verfahren gemäß der Erfindung wird als Substrat (1) einkristallines Silicium mit einer Dicke von etwa 400 bis 600 µm, vorzugsweise etwa 400 µm verwendet. Die Rückseite dieses Substrats ist mit einer etwa 0.5 bis 1 µm dicken Siliciumdioxidschicht (nicht abgebildet) versehen. Die Vorderseite des Substrats ist mit P+-Leitfähigkeit verursachenden Verunreinigungen, z. B. Bor bis zu einer Dotierungsgrenze (6) in etwa 2 bis 4 µm Tiefe dotiert. Die Dicke der dotierten Schicht ist definiert als der Abstand von der Substratoberfläche, bei dem die Dotierungskonzentration auf etwa 7 x 10¹⁹ Atome/cm³ abgefallen ist. Die Bordiffusion dient als Ätzbarriere bei einem späteren Dünnätzen des Siliciumwafers und bestimmt dadurch die Maskendicke. Weiterhin bewirkt die Borkonzentration eine Zugspannung in der fertigen Maske, die ein Durchbiegen der Maske verhindert, wenn die Maske in ihrem starren kalten Siliciumrahmen erwärmt wird. Zunächst werden mehrere Fenster von Chipgröße auf der Rückseite durch konventionelle Photolithographie und Naßätzen hergestellt. Durch diese Fenster wird später das Ätzen des Wafers vorgenommen. Auf das so vorbereitete Siliciumsubstrat (1) wird auf der Vorderseite eine Oxidschicht (2) bei etwa 800 °C in einer Sauerstoff- oder Sauerstoff-Wasser-Umgebung thermisch aufgewachsen.

Zur Herstellung der Photoresist- oder Polymerstruktur wird auf die Oberfläche der Oxidschicht (2) eine etwa 1 bis 2 µm dicke Polymer- oder Resistschicht (3) durch Aufschleudern oder Aufsprühen aufgetragen, gefolgt von einem Aushärteschritt bei etwa 200 °C für etwa 30 Minuten. Es gibt zahlreiche Materialien, aus denen die Schicht (3) hergestellt werden kann. Es können bekannte positive und negative Photoresistmaterialien, beispielsweise die üblichen Phenol-Formaldehyd-Novolakharze, Polymethylmethacrylate, Polyisoprene oder Materialien, die in den U. S. Patentschriften 3,201,239 und 3,770,433 beschrieben sind, verwendet werden. Es können aber auch Polymermaterialien, die nicht strahlungsempfindlich sind, wie z. B. Polyimide, zur Ausbildung der Schicht (3) verwendet werden.

In dem Verfahren gemäß der Erfindung wird als Schicht (3) der TNS-Photoresist aufgetragen, der in der U. S. Patentschrift 4,397,937 beschrieben ist und auf einem Phenolharz und einem Bisester einer 1-Oxo-2-naphthalinsulfonsäure mit einem asymmetrischen primären oder sekundären aliphatischen Diol als Sensibilisator basiert. Die Schichtdicke beträgt etwa 1.1 µm. Die Schicht (3) wird unter den oben angegebenen Bedingungen ausgehärtet.

Im Anschluß daran wird auf die Schicht (3) eine aus Plasmasiliciumnitrid oder -Oxid bestehende Schicht (4) aufgebracht. Das Siliciumnitrid wird als Ätzbarriere für das reaktive Ionenätzen mit Sauerstoff in einer Schichtdicke von etwa 0.1 µm durch Plasmaabscheidung aus einer Silan, Ammoniak und Argon haltigen Atmosphäre bei einem Druck von etwa 1 mbar, einer Abscheidungstemperatur von etwa 200 °C und einer Leistung von 100 Watt niedergeschlagen.

Auf die Plasmanitridschicht (4) wird als oberste Schicht eine Photoresistschicht (5) in einer Dicke von etwa 0.5 µm bis 1.0 µm aufgetragen. Die Schicht besteht in dem Verfahren gemäß der Erfindung aus dem gleichen Photoresist wie die Resistschicht (3). Sie kann aber auch aus einem anderen, gegen Strahlung hochempfindlichen Photoresist bestehen.

In der Schicht (5) wird in bekannter Weise durch bildmäßiges Belichten mit einer Wellenlänge von 436 nm, gefolgt von einem Aushärtschritt in Stickstoff bei einer Temperatur im Bereich von etwa 95 bis etwa 105 °C für etwa 30 Minuten und Entwickeln in wässrigem AZ-Entwickler auf der Basis von Tetramethylammoniumhydroxid ein gewünschtes Muster (7) mit vertikalen Seitenwänden erzeugt. Das Muster (7) wird dann mittels Trockenätzens in die Nitridschicht (4) und in die Resistschicht (3) übertragen, wobei die Übertragung in die Siliciumnitridschicht (4) durch Plasmaätzen mit CF₄, bei einem Fluß von etwa 20 bis etwa 50 sccm, einem Druck von etwa 30 bis etwa 60 µbar und einer Energiedichte von etwa 0.3 bis etwa 0.5 Watt/cm² , mit etwa 30 %iger Überätzung erfolgt. Der Endpunkt der Ätzung wird mittels Laserinterferenz bestimmt.

Die Schicht (4) mit den geätzten Öffnungen wird als Maske zum Ätzen der Photoresistschicht (3) verwendet. Als Ätzmedium wird Sauerstoff bei einem Fluß von etwa 40 bis etwa 60 sccm, einem Druck von etwa 2 bis etwa 10 µbar und einer Energiedichte von etwa 0.2 bis etwa 0.4 Watt/cm² verwendet. Um möglichst steile Resist- oder Polymerseitenwände zu erhalten, ist es vorteilhaft, das reaktive Ionenätzen bei einem niedrigen Sauerstoffdruck von etwa 2 µbar durchzuführen. Anschließend wird die Plasmanitridschicht (4) von der Photoresist-Struktur (7) entfernt in einem geeigneten RIE-Prozess, der PECVD-Nitrid gegenüber Oxid und Photoresist selektiv ätzt und CF₄ und O₂ verwendet, bei einem Fluß für CF₄ von 100 sccm und für O₂ von 8 sccm, einem Druck von etwa 265 µbar und einer Energiedichte kleiner etwa 0.1 Watt/cm² . Das Nitrid kann auch durch Ätzen mit heißer Phosphorsäure entfernt werden. Die resultierende Photoresiststruktur (7) weist eine Breite D größer/gleich etwa 1.0 µm auf, wobei D der spätere Linienabstand ist. Beim späteren Belichten in einem Elektronenstrahldrucker mittels Schattenwurf (EBP = E-beam proximity printing) kann die nach dem erfindungsgemäßen Verfahren gefertigte Maske um Bruchteile von D versetzt werden und so der minimale Linienabstand auf dem Wafer nochmals reduziert, d. h. die Integrationsdichte erhöht werden. Zum gleichen Zweck kann auch eine weitere Maske eingeblendet werden.

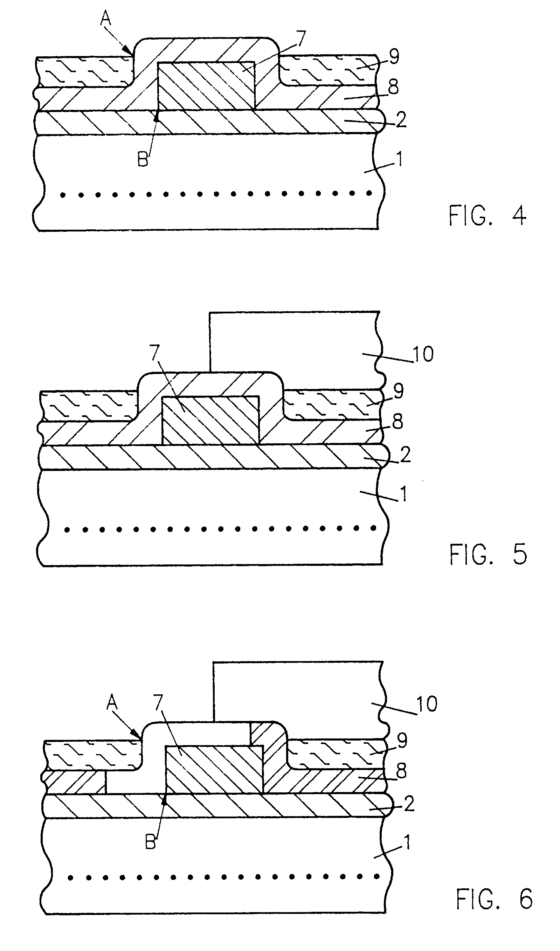

Die Resiststruktur (7) dient zur Definition der Lage und der Höhe der in den nun folgenden Prozeßschritten herzustellenden Nitridseitenwände. Gemäß Fig. 3 wird Siliciumnitrid (8) aus einem Plasma einer Silan, Ammoniak und Argon haltigen Atmosphäre bei einem Druck von etwa 1 mbar, einer Temperatur von etwa 210 °C und einer Leistung von 100 Watt in einer Schichtdicke von etwa 100 bis 500 nm abgeschieden. Das Siliciumnitrid (8) bedeckt alle horizontalen und vertikalen Oberflächen der Resiststruktur (7) und der Oxidschicht (2). Die Dicke d₁ auf den vertikalen Oberflächen ist etwas geringer als die Dicke dₒ auf den horizontalen Oberflächen und beträgt etwa 0.8 x dₒ. d₁ bestimmt die Linienbreite der gewünschten feinsten Strukturen. Anschließend wird zur Planarisierung der Struktur gemäß Fig. 3 auf die gesamte Oberfläche eine Photoresistschicht in einer Schichtdicke von etwa 2 bis 4 µm aufgetragen (nicht abgebildet). Hierzu kann ein Photoresist, der zuvor im Zusammenhang mit der Herstellung der Schichten (3) und (5), Fig. 2 beschrieben wurde, verwendet werden. Der Photoresist wird durch Bestrahlen mit UV-Strahlung (beispielsweise mit einer Wellenlänge von 436 nm) und durch Erhitzen auf etwa 150 bis etwa 180 °C für 30 Minuten ausgehärtet. Anschließend wird von der Resistschicht (9) so viel abgetragen, bis der Anfang der senkrechten Flanke der Seitenwandbedeckung der Resiststruktur (7), (Buchstabe A, Fig. 4) freigelegt ist. Der Abtrag erfolgt durch reaktives Ionenätzen in Sauerstoff bei einem Fluß von etwa 50 sccm, einem Druck von etwa 30 µbar und einer Energiedichte von etwa 0.2 bis 0.4 Watt/cm² . SEM 1 (Sekundärelektronenmikroskop- oder Rasterelektronenmikroskopaufnahme) entspricht Fig. 4 und zeigt die Seitenwand aus Siliciumnitrid (8) auf der Resiststruktur (7), sowie die Reste des Planarresists (9).

Die mit der Seitenwandtechnologie hergestellten Nitridseitenwände weisen zwar die gewünschten Submikrometerdimensionen auf, stellen aber immer geschlossene Figuren dar. Deshalb ist es erforderlich, die geschlossenen Figuren in offene überzuführen, bzw. die Strukturen aufzuteilen. Ein Verfahren, mit dem diese Aufteilung vorgenommen werden kann, ist beispielsweise im IBM Technical Disclosure Bulletin Vol. 27, No. 5, Oct. 1984, pp. 3090-91, H. J. Trumpp, "PROCESS FOR STRUCTURING A SUBMICRON MASK" beschrieben.

Zur Herstellung offener Strukturen wird gemäß der Erfindung eine Photoresistschicht (10) auf die planarisierte Struktur gemäß Fig. 4 aufgetragen. Die Resistschicht wird in bekannter Weise belichtet und entwickelt unter Erhalt der Trimm-Maske (10), Fig. 5. Die Fig. 5 entsprechende SEM 2 zeigt die Trimm-Maske auf der Nitridschicht (8).

Im nächsten Verfahrensschritt werden die horizontalen und vertikalen Bereiche der Nitridschicht (8), soweit sie nicht durch die Trimm-Maske (10) abgedeckt sind, durch isotropes Ätzen entfernt. Insbesondere der vertikale Bereich der Nitridschicht wird ohne Änderung seiner Dimensionen entfernt, und die Trimm-Maske (10) und der Planarresist (9) werden, weil es sich um ein isotropes Ätzen handelt, seitlich unterätzt. Dieser Schritt umfaßt entweder reaktives Ionenätzen in CF₄ mit einem Anteil von 8 Vol% Sauerstoff, bei einem Fluß von 20 sccm, einem Druck von etwa 30 µbar und einer Energiedichte von etwa 0.2 Watt/cm² oder Plasmaätzen in einem System der LFE-Corporation mit CF₄, bei einem Fluß von 100 sccm, einem Druck von etwa 100 µbar und einer Leistung von etwa 200 Watt. Die resultierende Struktur ist in Fig. 6, bzw SEM 3 dargestellt.

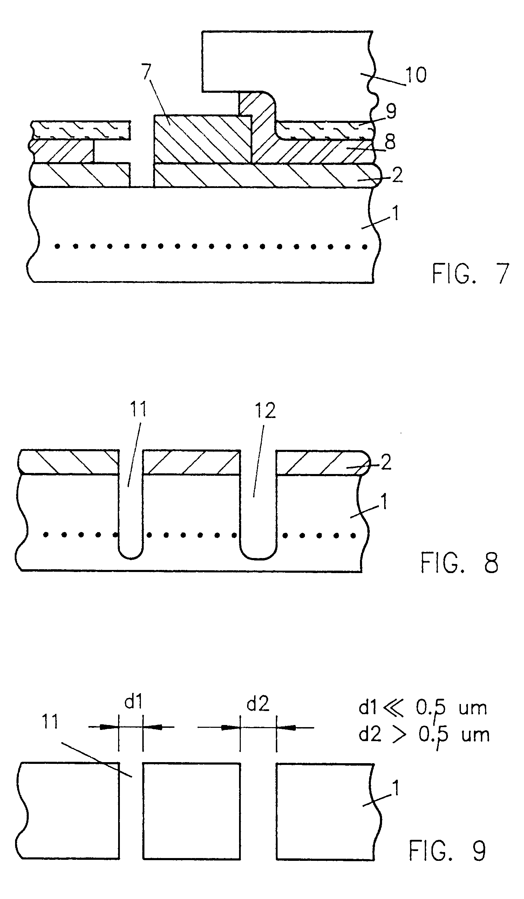

Im nächsten Verfahrensschritt wird in der Oxidschicht (2) die eigentliche Maskenöffnung zum Ätzen des Substrats (1) hergestellt. Hierzu wird die Öffnung, deren Abmessungen durch den Abstand A-B (Fig. 6) gegeben sind, in die Oxidschicht (2) durch reaktives Ionenätzen mit CF₄ oder CHF₃, bei einem Fluß von 30 sccm, einem Druck von 50 µbar und einer Energiedichte von 0.1 bis 0.3 Watt/cm² genauestens übertragen. Die resultierende Struktur ist in Fig. 7, bzw. SEM 4 dargestellt. Schließlich werden die Trimm-Maske (10) und der Rest der planarisierenden Resistschicht (9) durch Plasmaätzen in Sauerstoff, bei einem Fluß von 100 sccm, einem Druck von 100 µbar und einer Energiedichte von 0.2 bis 0.5 Watt/cm² entfernt. Das Plasmanitrid (8) auf der Oxidschicht (2) wird durch reaktives Ionenätzen mit CF₄/O₂, bei einem Fluß für CF₄ von 100 sccm und für O₂ von 8 sccm, einem Druck von etwa 265 µbar und einer Energiedichte < 0.1 Watt/cm² entfernt. Die Resiststruktur (7) wird durch Plasmaätzen mit Sauerstoff unter den zuvor angegebenen Bedingungen entfernt.

Gleichzeitig mit den Strukturen mit minimaler Linienbreite werden in der Maske Registriermarken hergestellt, mit deren Hilfe in einem zweiten Verfahrensabschnitt eine weitere Belichtung auf die Maske mit höchst genauer Überlagerung vorgenommen werden kann. Die Registriermarken bestehen aus einer großen Anzahl von periodisch angeordneten Quadraten mit einer Kantenlänge von etwa 1 µm. Da zu ihrer Herstellung die Seitenwandtechnologie angewendet wird, sind diese Quadrate von Gräben der minimal vorkommenden Linienbreite im Oxid umgeben. Da das Registriersignal im EBP-Verfahren durch Streuung von Elektronen an topographischen Strukturen, hier also an Gräben und Oxidflächen, erzeugt wird, ist der Signalverlauf für eine hochpräzise Registrierung ausreichend.

Auf die Struktur, von der Trimm-Maske (10), planarisierender Resist (9), Resiststruktur (7) und Plasmanitrid (8) entfernt sind, wird in einem zweiten Abschnitt des Verfahrens gemäß der Erfindung eine weitere Photoresistschicht aufgebracht. Als Photoresist kann ein Material, das zur Herstellung der Schichten (3) und (5) im ersten Verfahrensabschnitt verwendet wurde und dort beschrieben ist, verwendet werden. Zur Erzeugung des gewünschten Musters in der Photoresistschicht wird ein direkt schreibender Elektronenstrahl oder Ionenstrahl verwendet, der Strukturen mit einer Linienbreite von beispielsweise 0.5 bis 1.5 µm oder darüber, deren Herstellung völlig unkritisch ist, in die Resistschicht einschreibt. Für noch gröbere Strukturen, die vielen Chips oder Wafern gemeinsam sind, kann auch eine optische Belichtung angewendet werden. Die gewünschten Strukturen in dieser Photoresistschicht kommen zwischen den im ersten Verfahrensabschnitt mittels der Seitenwandtechnologie in der Oxidschicht (2) erzeugten Strukturen minimaler Linienbreite zu liegen. Die Ausrichtung des Elektronenstrahls auf die im ersten Verfahrensabschnitt erzeugten Registriermarken ist an sich bekannt und braucht nicht näher erläutert zu werden.

Nach einem Aushärtschritt wird die belichtete Photoresistschicht in einem alkalischen wässrigen Entwickler entwickelt unter Erhalt des gewünschten Musters. Die für das direkt schreibende Elektronenstrahlbelichtungsverfahren begrenzte Feldgröße ist in diesem zweiten Verfahrensabschnitt von untergeordneter Bedeutung, weil, wegen der größeren Linienbreiten, die in diesem Verfahrensabschnitt geschrieben werden, ein Anschließen von einzelnen Feldern zur Herstellung einer Maske in der gewünschten Größe unproblematisch ist. In diesem Zusammenhang wird noch einmal auf die oben abgehandelte Fig. 1 C verwiesen, aus der ersichtlich ist, daß bei einer Unterbrechung des zu druckenden Linienmusters bei größerer Linienbreite in dem resultierenden Resistmuster, im Gegensatz zu Resistmustern mit minimaler Linienbreite, nur eine Einschnürung gebildet wird und keine Linienunterbrechung stattfindet. Die zuvor beschriebenen Schritte des zweiten Verfahrensabschnitts sind zeichnerisch nicht dargestellt.

Das Muster in der weiteren Photoresistschicht wird auch durch reaktives Ionenätzen in die Oxidschicht (2) übertragen. Die strukturierte Oxidschicht mit Öffnungen für Linienbreiten d₁ « 0.5 µm und Öffnungen für Linienbreiten d₂ > 0.5 µm dient als Maske zum reaktiven Ionenätzen des Siliciumsubstrats (1). Bei diesem Schritt werden Gräben (11, 12) in das Siliciumsubstrat (1) geätzt. Das reaktive Ionenätzen wird unter folgenden Bedingungen durchgeführt: Ätzmedium: HCl-Gas, Fluß: 80 bis 120 sccm, Druck: 40 bis 110 µbar, Energiedichte < 0.3 Watt/cm² . Dieses Ätzen wird in einem Reaktor AME 8300 durchgeführt. Die Ätzung kann auch in einem AME 5000 Reaktor durchgeführt werden. Allerdings sind die Ätzparameter geräteabhängig. Die Tiefe der geätzten Gräben reicht über die Dotierungsgrenze (6) im Siliciumsubstrat (1) hinaus. Die resultierende Struktur ist in Fig. 8 dargestellt. SEM 5 zeigt Gräben (11) mit minimaler Linienbreite in einem Siliciumsubstrat (1).

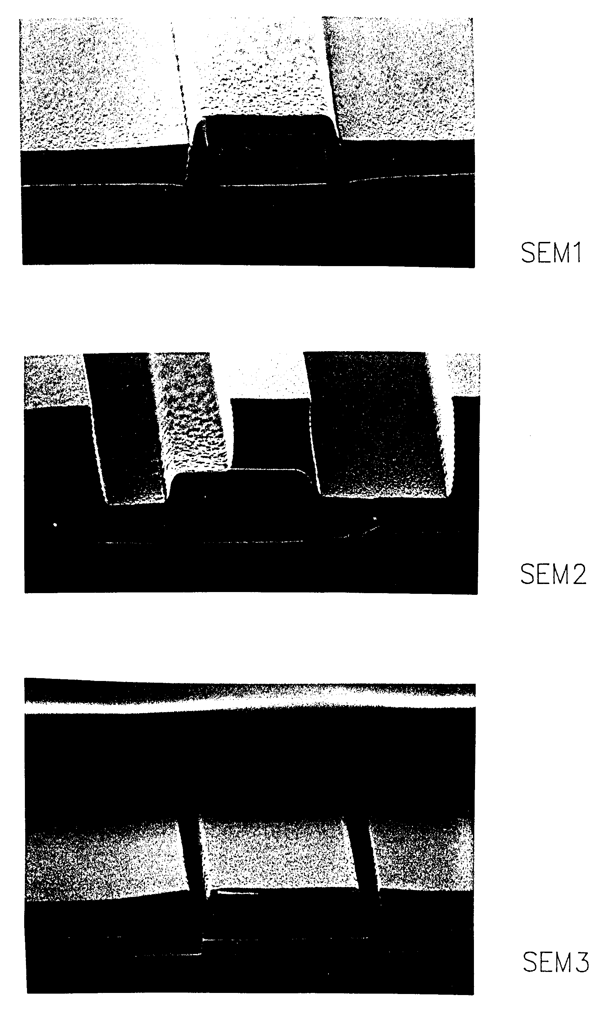

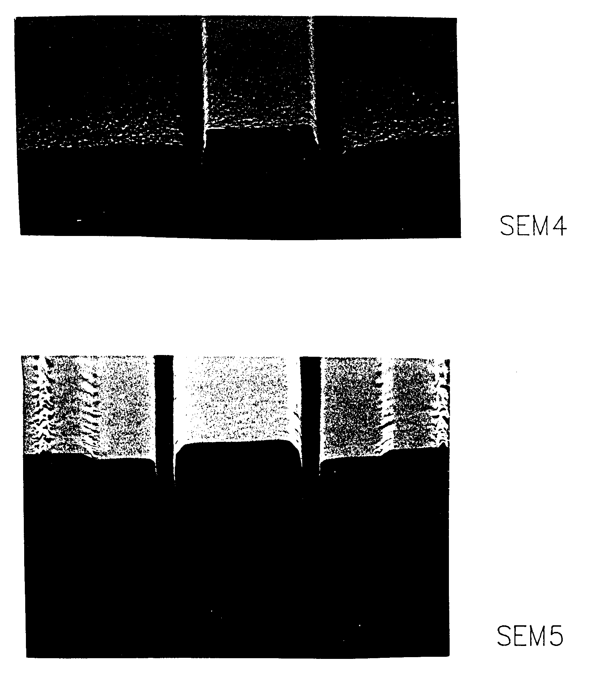

Alsdann wird das Siliciumsubstrat (1) durch die Öffnungen in der Siliciumdioxidschicht auf der Rückseite des Wafers in einem Naßprozeß gerichtet geätzt. Die dazu verwendete Ätzlösung besteht aus Ethylendiamin, Brenzcatechin und Wasser. Das Ätzen hört auf bei einer Borkonzentration von 7 x 10¹⁹ Boratomen /cm³. Die resultierende Maske aus der einkristallinen bordotierten Siliciummembran ist etwa 2 µm dick, in Abhängigkeit von der angewendeten Bordiffusion. Die Siliciumdioxidschichten werden von beiden Seiten des Substrats durch Ätzen mit gepufferter Flußsäure entfernt. Die resultierende Maske ist in Fig. 9 dargestellt. Die Siliciummembran wird dann noch mit einer 0.2 bis 0.8 µm dicken Goldschicht belegt (nicht dargestellt). Die Goldschicht kann einen Elektronenstrahl bis zu Energien von etwa 25 keV abbremsen.

Die nach dem erfindungsgemäßen Verfahren hergestellten Masken können in einem Elektronenstrahldrucker verwendet werden, mit dem Muster mit diesen Dimensionen in einem Schattenwurfverfahren auf mit Photoresist beschichtete Wafer übertragen werden.

## Patentansprüche

1. Verfahren zum Herstellen von Strukturen im Submikrometerbereich,
dadurch gekennzeichnet,
A
a) daß zunächst auf ein Siliciumsubstrat (1) eine erste Isolierschicht (2) oder eine Folge von Isolierschichten aufgebracht wird;
b) daß auf die Schicht (2) eine Photoresist-oder Polymerschicht (3) aufgebracht wird und Teile dieser Schicht wieder entfernt werden unter Ausbildung von Photoresist- oder Polymerstrukturen (7), die neben horizontalen Oberflächen auch im wesentlichen vertikale Oberflächen aufweisen;
c) daß auf die horizontalen und im wesentlichen vertikalen Oberflächen der Photoresist- oder Polymerstrukturen (7), sowie auf die freiliegenden Bereiche der ersten Isolierschicht (2) eine zweite Isolierschicht (8) aufgebracht wird;
d) daß auf die resultierende Struktur zur Oberflächenplanarisierung ein Photoresist oder Polymermaterial (9) aufgetragen und ganzflächig zurückgeätzt wird, bis der Anfang der senkrechten Flanken der Seitenwandbedeckung durch die zweite Isolierschicht (8) auf den Strukturen (7) freigelegt ist;
e) daß in einem photolithographischen Prozeß auf der Oberfläche der zweiten Isolierschicht (8) und der Planarresist- oder Polymerschicht (9) eine Trimm-Maske (10) erzeugt wird, wobei ein vertikaler Bereich der Isolierschicht (8) von dieser Trimm-Maske (10) nicht abgedeckt wird;
f) daß die freiliegenden Bereiche der zweiten Isolierschicht (8) durch isotropes Ätzen entfernt werden;
g) daß die Abmessungen (A-B) der Öffnungen, die nach Entfernen der zweiten Isolierschicht (8) von den vertikalen Oberflächen der Photoresist- oder Polymerstruktur (7) und den vertikalen Oberflächen der Planarresist- oder Polymerschicht (9) definiert sind, durch anisotropes Ätzen in die erste Isolierschicht (2) übertragen werden;
h) daß die Trimm-Maske (10), der planarisierende Resist oder das Polymermaterial (9), die Resist- oder Polymerstruktur (7) und die Reste der zweiten Isolierschicht (8) durch Ätzen entfernt werden;
B
a) daß auf die erste Isolierschicht (2) eine weitere Photoresistschicht aufgetragen wird und in einem photolithographischen Prozeß Muster von Öffnungen für Linienbreiten > 0.5 µm erzeugt werden;
b) daß diese Muster durch anisotropes Ätzen ebenfalls in die erste Isolierschicht (2) übertragen werden;
C
a) daß unter Verwendung der ersten Isolierschicht als Maske in dem Siliciumsubstrat (1) durch anisotropes Ätzen Gräben mit einer gewünschten Tiefe hergestellt werden und
b) die erste Isolierschicht (2) durch Naßätzen entfernt wird.

2. Verfahren nach Anspruch 1, dadurch gekennzeichnet, daß zur Herstellung der Photoresist- oder Polymerstrukturen (7) mit horizontalen und im wesentlichen vertikalen Oberflächen Schichten (3, 4 und 5) auf die erste Isolierschicht (2) aufgebracht werden, wobei die auf die Isolierschicht (2) direkt aufgebrachte Schicht (3) aus einem Photoresist oder Polyimid, die Schicht (4) aus Plasmasiliciumnitrid oder -Oxid und die Schicht (5) aus einem Photoresist bestehen;
daß das gewünschte Muster in der obersten Schicht (5) erzeugt wird und durch reaktives Ionenätzen in die Plasmanitrid- oder Oxidschicht (4) bzw. in die Photoresist- oder Polyimidschicht (3) übertragen wird.

3. Verfahren nach Anspruch 2, dadurch gekennzeichnet, daß die untere Schicht (3) etwa 1.1 µm dick ist und aus einem Resist auf Phenolharzbasis mit einem Bisester einer 1-Oxo-2-naphthalinsulfonsäure mit einem asymmetrischen primären oder sekundären aliphatischen Diol als Sensibilisator besteht; die Schicht (4) etwa 0.1 µm dick ist und aus Plasmanitrid besteht und die oberste Schicht (5) etwa 0.5 bis 1.0 µm dick ist und aus dem Photoresist der unteren Schicht besteht.

4. Verfahren nach den Ansprüchen 2 und 3, dadurch gekennzeichnet, daß das gewünschte Muster (7) in der obersten Schicht (5) durch bildmäßiges Belichten, Härten und Entwickeln erzeugt wird und durch Plasmaätzen mit CF₄ in die Schicht (4) aus Plasmanitrid und durch reaktives Ionenätzen mit Sauerstoff bei einem Druck von etwa 2 µbar in die Photoresistschicht (3) übertragen wird.

5. Verfahren nach Anspruch 1, dadurch gekennzeichnet, daß das Substrat (1) aus einkristallinem Silicium mit einer Dicke von etwa 400 bis 600 µm besteht, das mit P+-Leitfähigkeit verursachenden Verunreinigungen, z. B. Bor, bis zu einer Dotierungsgrenze (6) in etwa 2 bis 4 µm Tiefe dotiert ist.

6. Verfahren nach Anspruch 1, dadurch gekennzeichnet, daß die erste Isolierschicht (2) aus Siliciumdioxid besteht, welche durch thermisches Aufwachsen auf dem Siliciumsubstrat (1) bei etwa 800 °C in einer Sauerstoff- oder Sauerstoff-Wasser-Umgebung hergestellt wird.

7. Verfahren nach den Ansprüchen 1 bis 4, dadurch gekennzeichnet, daß auf den horizontalen und im wesentlichen vertikalen Wände der Resiststruktur (7) und auf den freiliegenden Bereichen der Oxidschicht (2) Siliciumnitrid (8) in einer Schichtdicke von etwa 100 bis 500 nm aus einem Plasma einer Silan, Ammoniak und Argon haltigen Atmosphäre bei einem Druck von etwa 1 mbar, einer Temperatur von etwa 210 °C und einer Leistung von etwa 100 Watt abgeschieden wird.

8. Verfahren nach Anspruch 7, dadurch gekennzeichnet, daß nach der Oberflächenplanarisierung der mit Plasmanitrid (8) bedeckten Resiststrukturen (7) mit einem Photoresist und dem ganzflächigem Rückätzen bis zur Freilegung des Anfangs der senkrechten Flanken der Seitenwandbedeckung durch die Plasmanitridschicht (8) und dem Aufbringen einer Trimm-Maske (10) die freiliegenden horizontalen und vertikalen Bereiche der Plasmanitridschicht (8) durch reaktives Ionenätzen in CF₄ mit einem Anteil von 8 Vol% Sauerstoff, bei einem Fluß von 20 sccm, einem Druck von etwa 30 µbar und einer Energiedichte von etwa 0.2 Watt/cm² oder durch Plasmaätzen mit CF₄, bei einem Fluß von 100 sccm, einem Druck von etwa 100 µbar und einer Leistung von etwa 200 Watt entfernt werden.

9. Verfahren nach Anspruch 6 in Kombination mit 7 oder, Anspruch 6 in Kombination mit 8, dadurch gekennzeichnet, daß die Öffnungen deren Abmessungen durch den Abstand A-B gegeben sind und die durch das Entfernen der Plasmanitridschicht (8) von den vertikalen Oberflächen der Resiststruktur (7) gebildet wurden, durch reaktives Ionenätzen mit CF₄ oder CHF₃, bei einem Fluß von 30 sccm, einem Druck von 50 µbar und einer Energiedichte von 0.1 bis 0.3 Watt/cm² in die Siliciumdioxidschicht (2) übertragen werden.

10. Verfahren nach Anspruch 6, dadurch gekennzeichnet, daß gleichzeitig mit der Herstellung der Strukturen minimaler Linienbreite mittels der Seitenwandtechnologie Registriermarken in der Siliciumdioxidschicht (2) hergestellt werden, mit deren Hilfe in einem weiteren lithographischen Prozeß (Ba, b) eine weitere Belichtung auf eine Photoresistschicht auf der Oxidschicht (2) mit höchst genauer Überlagerung vorgenommen werden kann.

11. Verfahren nach den Ansprüchen 6 und 10, dadurch gekennzeichnet, daß das Muster in der Photoresistschicht ebenfalls in die Oxidschicht (2) durch reaktives Ionenätzen übertragen wird.

12. Verfahren nach einem oder mehreren der Ansprüche 6, 9, 10 und 11, dadurch gekennzeichnet, daß unter Verwendung der Oxidschicht (2) mit Öffnungen « 0.5 µm und > 0.5 µm durch reaktives Ionenätzen mit HCl-Gas, bei einem Fluß von 80 bis 120 sccm, einem Druck von 40 bis 110 µbar und einer Energiedichte von < 0.3 Watt/cm² in dem Siliciumsubstrat (1) Gräben (11, 12) hergestellt werden.

13. Verfahren nach Anspruch 12 in Kombination mit 5, dadurch gekennzeichnet, daß das reaktive Ionenätzen so lange durchgeführt wird, bis die Tiefe der Gräben über die Dotierungsgrenze (6) im Siliciumsubstrat (1) hinausreicht.

14. Verfahren nach Anspruch 13, dadurch gekennzeichnet, daß die Rückseite des Substrats mit einer Siliziumdioxidschicht mit Öffnungen versehen ist und daß zwischen Schritten (Ca) und (Cb) das Siliciumsubstrat (1) von der Rückseite her durch gerichtetes Ätzen mit einer Ätzlösung aus Ethylendiamin, Brenzcatechin und Wasser gedünnt wird, wobei das Ätzen bei einer Borkonzentration von etwa 7 x 10¹⁹ Boratomen/cm³ aufhört.

15. Verfahren nach Anspruch 14, dadurch gekennzeichnet, daß Siliciumdioxidschichten von der Vorder- und Rückseite des Siliciumsubstrats (1) durch Ätzen mit gepufferter Flußsäure entfernt werden.

## Claims

1. Process for making structures in the submicron range, characterized in that
A
a) initially a first insulating layer (2) or a sequence of insulating layers is deposited on a silicon substrate (1);
b) layer (2) is covered with a photoresist or a polymer layer (3) and parts of this layer are removed, forming photoresist or polymer structures (7) comprising, in addition to horizontal surfaces, substantially vertical surfaces;
c) a second insulating layer (8) is deposited on the horizontal and substantially vertical surfaces of the photoresist or polymer structures (7) as well as on the bared areas of the first insulating layer (2);
d) a photoresist or polymer material (9) is deposited on the resultant structure for surface planarization and etched back in full until the start of the vertical edges of the side wall coating formed by the second insulating layer (8) is bared on the structures;
e) in a photolithographic step, a trimming mask (10), is produced on the surface of the second insulating layer (8) and the planarizing resist or polymer layer (9); whereby a vertical region of the insulating layer (8) is not covered by said trimming mask (10).
f) the bared regions of the second insulating layer (8) are removed by isotropic etching;
g) the dimensions (A-B) of the openings, defined after removal of the second insulating layer (8) from the vertical surfaces of the photoresist or polymer structure (7) and the vertical surfaces of the planar resist - or polymer layer (9), are transferred by anisotropic etching to the first insulating layer (2);
h) the trimming mask (10), the planarizing resist or the polymer material (9), the resist or polymer structure (7) and the remainder of the second insulating layer (8) are removed by etching;
B
a) a further photoresist layer is deposited on the first insulating layer (2), and hole patterns for line widths > 0.5 µm are generated in a photolithographic step;
b) these structures are also transferred to the first insulating layer (2) by anisotropic etching;
C
a) using the first insulating layer as a mask, trenches with a desired depth are produced by anisotropic etching in the silicon substrate (1);
b) the first insulating layer (2) is removed by wet etching.

2. Process according to claim 1,
characterized in that
for producing the photoresist or polymer structures (7) with horizontal and substantially vertical surfaces, layers (3, 4 and 5) are deposited on the first insulating layer (2), with layer (3) directly applied to insulating layer (2) being made of a photoresist or polyimide, layer (4) being made of plasma silicon nitride or oxide, and layer (5) being made of a photoresist;
the desired pattern in the top-most layer (5) is produced and transferred by reactive ion etching to the plasma nitride or oxide layer (4) and the photoresist and polyimide layer (3), respectively.

3. Process according to claim 2,
characterized in that
the bottom layer (3) is about 1.1 µm thick and consists of a resist based on phenolic resin with a bisester of a 1-oxo-2-naphthalene sulfonic acid with an unsymmetrical primary or secondary alphatic diol as a sensitizer, layer (4) being about 0.1 µm thick and consisting of plasma nitride, and the top-most layer (5) being about 0.5 to 1.0 µm thick and consisting of the photoresist of the bottom layer.

4. Process according to claims 2 and 3,
characterized in that the desired pattern (7) in the top-most layer (5) is produced by imagewise exposure, curing and development and transferred by plasma etching with CF₄ to layer (4) of plasma nitride and by reactive ion etching with oxygen at a pressure of about 2 µbar to photoresist layer (3).

5. Process according to claim 1,
characterized in that the substrate (1) consists of a monocrystalline silicon with a thickness of about 400 to 600 µm which is doped with a P+ conductivity producing dopant, such as boron, up to a doping level (6) at a depth of about 2 to 4 µm.

6. Process according to claim 1,
characterized in that the first insulating layer (2) consists of silicon dioxide and is produced by being thermally grown on top of the silicon substrate (1) at about 800° C in an oxygen or oxygen/water ambient.

7. Process according to claims 1 to 4,
characterized in that silicon nitride (8) with a layer thickness of about 100 to 500 nm is deposited on the horizontal and substantially vertical walls of the resist structure (7) and the bared regions of the oxide layer (2) from a plasma of an atmosphere containing silane, ammonia and argon at a pressure of about 1 mbar, a temperature of about 210° C and a power of about 100 Watt.

8. Process according to claim 7,
characterized in that after surface planarization of the plasma nitride (8) coated resist structures (7) with a photoresist and blanket etching until the start of the vertical edges of the sidewall coating formed by the plasma nitride layer (8) is bared, and by using a trimming mask (10), the bared horizontal and vertical regions of the plasma nitride layer (8) are removed by reactive ion etching in CF₄ with 8 vol% oxygen, at a flow rate of 20 sccm, a pressure of about 30 µbar and an energy density of about 0.2 Watt/cm² or by plasma etching with CF₄ at a flow rate of 100 sccm, a pressure of about 100 µbar and a power of about 200 Watt.

9. Process according to claim 6 in combination with claim 7 or claim 6 in combination with claim 8,
characterized in that the openings, whose dimensions are defined by the spacing A-B and which are formed by removing the plasma nitride layer (8) from the vertical surfaces of the resist structure (7) are transferred by reactive ion etching with CF₄ or CHF₃, at a flow rate of 30 sccm, a pressure of 50 µbar and an energy density of 0.1 to 0.3 Watt/cm² to the silicon dioxide layer (2).

10. Process according to claim 6,
characterized in that concurrently with the structures of minimum line width, registration marks are produced in the silicon dioxide layer (2) by sidewall technology, said marks being used in a further lithographic step (Ba, b) to further expose a photoresist layer on the oxide layer (2) with maximum superposition.

11. Process according to claims 6 and 10,
characterized in that the pattern in the photoresist layer is also transferred to the oxide layer (2) by reactive ion etching.

12. Process according to any one or a combination of claims 6, 9, 10 and 11,
characterized in that by using the oxide layer (2) with openings << 0.5 µm and > 0.5 µm, trenches (11, 12) are produced in the silicon substrate (1) by reactive ion etching with HCl gas at a flow rate of 80 to 120 sccm, a pressure of 40 to 110 µbar and an energy density of <0.3 Watt/cm².

13. Process according to claim 12 in combination with claim 5,
characterized in that reactive ion etching is carried out until the depth of the trenches exceeds the doping limit (6) in the silicon substrate (1).

14. Process according to claim 13,
characterized in that the back side of the substrate is provided with a layer of silicon dioxide having openings therein and that the silicon substrate (1) is thinned from the back side between steps (Ca) and (Cb) by anisotropic etching with an etch solution of ethylene diamine, pyrocatechol, and water, with etching terminating at a boron concentration of about 7 x 10¹⁹ boron atoms/cm³.

15. Process according to claim 14,
characterized in that the silicon dioxide layers are removed from the front and the back side of the silicon substrate (1) by etching with buffered hydrofluoric acid.

## Revendications

1. Procédé pour la fabrication de structures dans le domaine de la submicroscopie, caractérisé par le fait que,
A
a) on applique d'abord sur une couche de substrat de silicium (1) une première couche isolante (2) ou des couches isolantes successives;
b) on applique sur la couche (2) une couche photorésiste ou polymère (3) et qu'on enlève des parties de cette couche sous la formation de structures photorésistes ou polymères (7), qui présentent, entre des surfaces horizontales des surfaces substantiellement verticales;
c) on applique une deuxième couche isolante (8) sur les surfaces horizontales et substantiellement verticales de la structure photorésiste ou polymère (7), ainsi que sur les zones dégagées de la première couche isolante (2);
d) on applique sur la structure qui en résulte, un photorésiste ou un matérial polymère (9) pour aplanir la surface et on attaque toute la surface à nouveau jusqu'au moment, où, sur les structures (7), le début des bords verticaux de la couverture des parois latérales sera dégagé par la deuxième couche isolante (8);
e) on réalise dans un processus photolithographique, sur la surface de la deuxième couche isolante (8) et la couche planar-résiste ou polymère (9), un masque d'ajustement (10), sachant que ce faisant, une zone verticale de la couche isolante (8) n'est pas couverte par ce masque d'ajustement (10);
f) les zones dégagées de la deuxième couche isolante (8) sont enlevées par la gravure isotropique;
g) les mesures (A-B) des ouvertures, qui sont définies, après l'enlèvement de la deuxième couche isolante (8), par les surfaces verticales des structures photorésistes ou polymères (7) et par les surfaces verticales de la couche planar-résiste ou polymère (9), sont transférées par la gravure anisotropique dans la première couche isolante (2);
h) le masque d'ajustement (10), le résiste aplanissant ou le matérial polymère (9), la structure résiste ou polymère (7) et les restes de la deuxième couche isolante (8), sont enlevés par la gravure;
B
a) on applique sur la première couche isolante (2) une couche supplémentaire de photorésiste et on réalise dans un processus photo-lithographique des dessins d'ouvertures pour des traits d'une largeur de > 0.5 µm;
b) ces dessins sont également transférés par la gravure anisotropique dans la première couche isolante (2);
C
a) on réalise, en utilisant la première couche isolante comme masque, des tranchées de la profondeur souhaitée par la gravure isotropique dans le substrat de silicium (1) et
b) la première couche isolante (2) est enlevée par gravure humide.

2. Procédé selon la revendication 1, caractérisé par le fait que l'on applique, sur la première couche isolante (2), des couches (3, 4 et 5) pour réaliser des structures photorésistes ou polymères (7) avec des surfaces horizontales, et substantiellement verticales, où la couche directement appliquée (3) sur la couche isolante (2), est composée de photorésiste ou polyamide, et la couche (4) de nitrure de silicium plasmatique ou d'oxyde de silicium plasmatique, et la couche (5) est composée d'un photorésiste;
que le dessin désiré est réalisé dans la couche supérieure (5) et est transféré par gravure par ions réactifs dans la couche du plasma de nitrure ou dans la couche d'oxyde (4), respectivement, dans la couche photorésiste ou polyimide (3).

3. Procédé selon la revendication 2, caractérisé par le fait que la couche inférieure (3) a une épaisseur d'environ 1.1 µm et se compose d'un résiste basé sur de la résine phénoplaste avec un "bisester" d'un acide naphtaline- sulfonique de 1-Oxo-2 avec un diol asymétrique primaire ou aliphatique secondaire comme sensibilisateur; que la couche (4) a une épaisseur d'environ 1 µm et se compose de nitrure de plasma et que la couche supérieure (5) a une épaisseur d'environ 0.5 à 1.0 µm et se compose du photorésiste de la couche inférieure.

4. Procédé selon les revendications 2 et 3, caractérisé par le fait que le dessin désiré (7) est réalisé dans la couche supérieure (5), par impression exposée, durcissement et développement, et transféré dans la couche en nitrure de plasma (4) par gravure plasmatique avec CF₄ et dans la couche photorésiste (3) par gravure par ions réactifs à l'aide d'oxygène avec une pression d'environ 2 µbar.

5. Procédé selon la revendication 1, caractérisé par le fait que le substrat (1) se compose d'un silicium monocristallin d'une épaisseur d'environ 400 à 600 µm, qui est dopé d'impuretés causant une conductibilité P+ par ex. au bore, jusqu'à une limite de dopage (6) dans une profondeur d'environ 2 à 4 µm.

6. Procédé selon la revendication 1 caractérisé par le fait que la première couche isolante (2) se compose de dioxyde de silicium, qui est réalisé par épitaxie thermique sur le substrat de silicium (1) à environ 800° C dans un environnement d'oxygène ou d'eau-oxygène.

7. Procédé selon l'une quelconque des revendications 1 à 4, caractérisé par le fait que: l'on dépose sur les parois horizontales et sur les parois substantiellement verticales de la structure résiste (7) et sur les zones dégagées de la couche d'oxyde (2), du nitrure de silicium (8) dans une épaisseur de couche d'environ 100 à 500 µm, d'un plasma d'une atmosphère contenant du silane, de l'ammoniac et de l'argon avec une pression d'environ 1 mbar, une température d'environ 210°C et d'une puissance d'environ 100 Watt.

8. Procédé selon la revendication 7, caractérisé par le fait qu'après avoir aplani avec un photorésiste les surfaces des structures résistes (7) recouvertes de nitrures de plasma (8) et la rétrogravure de toute la surface jusqu'au dégagement du début des bords verticaux de la couverture des parois latérales à travers la couche de nitrure de plasma (8), et l'application du masque d'ajustement (10), on enlève les zones dégagées horizontales et verticales de la couche de nitrure de plasma (8) par gravure par ions réactifs en CF₄ avec une part d'oxygène de 8 volumes %, un débit de 20 sccm, une pression d'environ 30 µbar et une densité d'énergie d'environ 0.2 Watt/cm², ou par gravure plasmatique avec CF₄ avec un débit de 100 sccm, une pression d'environ 100 µbar et une puissance d'environ 200 Watt.

9. Procédé selon la revendication 6 en combinaison avec 7, ou la revendication 6 en combinaison avec 8, caractérisé par le fait que les ouvertures, dont les mesures sont déterminées par la distance A-B et qui ont été fournies par l'enlèvement de la couche de nitrure de plasma (8) des surfaces verticales de la structure résiste (7), sont transférées dans la couche de d'dioxyde de silicium (2) par une gravure par ions réactifs avec CF₄ ou CHF₃, avec un débit de 30 sccm, une pression de 50 µbar et une densité d'énergie de 0.1 à 0.3 Watt/cm².

10. Procédé selon la revendication 6, caractérisé par le fait que parallèlement à la réalisation des structures d'une largeur minimale des traits au moyen de la technique des parois latérales, on produit des marques d'enregistrement dans la couche de dioxyde de silicium (2) à l'aide desquelles on peut, dans un processus lithographique (BA,b), réaliser une exposition supplémentaire, sur une couche photorésiste, sur la couche d'oxyde (2) avec une superposition extrêmement précise.

11. Procédé selon les revendications 6 et 10, caractérisé par le fait que le dessin dans la couche photorésiste est également transféré dans la couche d'oxyde (2) par gravure par ions réactifs ;

12. Procédé selon l'une quelconque des revendications 6, 9, 10 et 11, caractérisé par le fait qu'on réalise dans le substrat de silicium (1), par gravure par ions réactifs avec du gas HCL, avec un débit de 80 à 120 sccm, une pression de 40 à 110 µbar et une densité d'énergie de < 0.3 Watt/cm², des tranchées (11, 12) en utilisant la couche d'oxyde (2) avec des ouvertures << 0.5µm et > 0.5 µm.

13. Procédé selon la revendication 12 en combinaison avec 5, caractérisé par le fait que l'on continue la gravure par ions réactifs jusqu'au moment, où la profondeur des tranchées dépassent la limite de dopage (6) dans le substrat de silicium (1).

14. Procédé selon la revendication 13, caractérisé par le fait que, l'arrière du substrat est fournit avec une couche de dioxyde de silicium avec des ouvertures, et qu'on amincit le substrat de silicium (1) entre les phases (Ca) et (Cb) par la face arrière, à l'aide d'une gravure rectifiée avec une solution de gravure d'ethylenediamine, de pyrocatechine et d'eau et où l'on arrête la gravure à une concentration en bore d'environ 7 x 10¹⁹ bore-atomes/cm³.

15. Procédé selon la revendication 14, caractérisé par le fait que les couches de dioxyde de silicium sont enlevées de l'arrière et l'avant du substrat de silicium (1) par gravure avec de l'acide fluorhydrique tamponné.
